# EUROPEAN PATENT APPLICATION

(11) **EP 1 231 820 A1**
(43) Date of publication of application: **14.08.2002**
(21) Application number: 01926084.3
(22) Date of filing: 01.05.2001
(51) Int. Cl.: H05B 3/10, H05B 3/20, H01L 21/68, H01L 21/027

(54) **CERAMIC HEATER**

(30) Priority: 02.05.2000 JP 2000133942
(71) Applicant: IBIDEN CO., LTD., Ogaki-shi Gifu-ken 503-0917 (JP)
(72) Inventor: ITO, Yasutaka, c/o IBIDEN CO., LTD, Ibi-gun, Gifu 501-0695 (JP); HIRAMATSU, Yasuji, c/o IBIDEN CO., LTD, Ibi-gun, Gifu 501-0695 (JP)
(74) Representative: Gillard, Marie-Louise
(86) International application number: JP0103759
(87) International publication number: WO0184885

(57) **Abstract**

The objective of the present invention is to provide a heater wherein it is easy to forcibly cool the remaining heat of a heating element, wherein it is easy to control the resistance value of the heating element, wherein the temperature of the periphery does not become lower than a set value and wherein no cracks are generated by rapid temperature rising and rapid temperature falling. The present invention provides a ceramic heater comprising a ceramic substrate and a resistance heating element formed on the surface of the ceramic substrate, wherein the outermost circumference of a resistance heating element-formed area is located within 35 mm from the side face of the ceramic substrate.

## Description

### Technical Field

The present invention relates to a ceramic heater used principally in semiconductor industry.

### Background Art

Semiconductors are very important products necessary in various industries. Semiconductor chips are produced, for example, by slicing a silicon monocrystal into a predetermined thickness to produce a silicon wafer, and then forming a plurality of integrated circuits and the like on the silicon wafer.

In a process for manufacturing such semiconductor chips, a silicon wafer put on an electrostatic chuck is subjected to various treatments such as etching, CVD and the like to form a conductor circuit, an element and the like. Moreover, a resin for a resist is applied and then is heated to dry.

For such heating, ceramic heaters are used, and heaters in which carbide or nitride is used are disclosed in JP Kokai Hei 11-74064, JP Kokai Hei 11-40330 and the like.

### Summary of the Invention

However, the heater disclosed in JP Kokai Hei 11-74064 has a heating element embedded therein and has a problem that the remaining heat cannot be cooled forcibly or the resistance value of the heating element is not easily controlled.

The technology disclosed in JP Kokai Hei 11-40330 can solve such problem since a resistance heating element is arranged outside. However, there has been a problem: that a temperature of the periphery of a heating face of a ceramic substrate becomes lower than a set value; or that cracks are generated by rapid temperature rising or rapid temperature falling.

The present invention was made in view of the above-mentioned problem and an objective of the present invention is to provide a heater in which: the residual heat of the heating element can be easily cooled forcibly; the resistance value of the heating element can be easily controlled; the temperature of its periphery does not become lower than a set value; and further, no cracks are generated due to rapid temperature rising or rapid temperature falling.

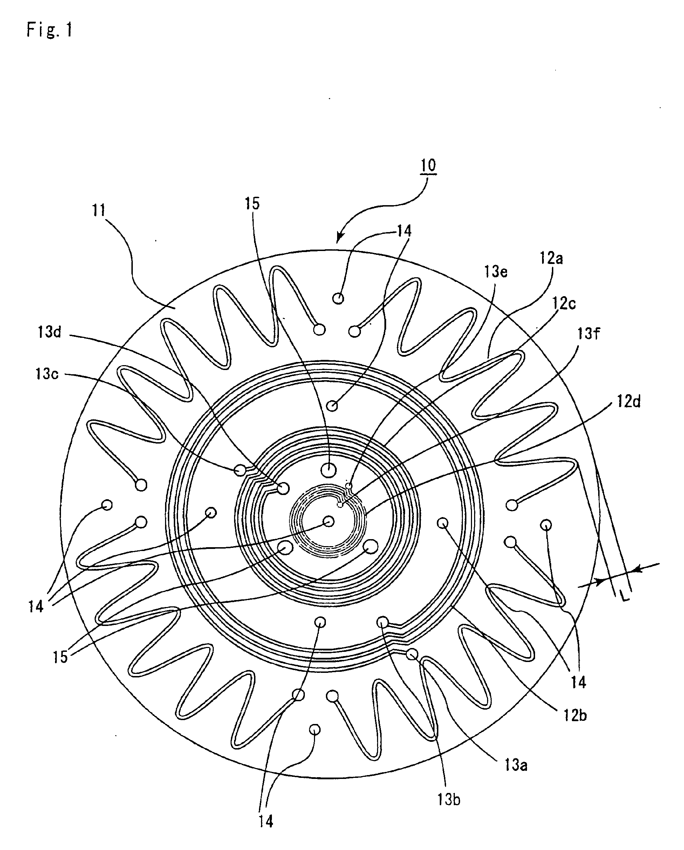

The inventors of the present invention studied intensely to achieve the above-mentioned objective and, as a result, they have found that: the heater disclosed in JP Kokai Hei 11-74064 has an insulating ring being arranged in a peripheral portion as shown in Fig. 1 of JP Kokai 2000-299281, thus a heating element is not formed in the peripheral portion which is within approximately 40 mm from the outer circumference thereof, and therefore the temperature adjacent to the periphery falls and the degree of thermal expansion in the vicinity of the periphery differs from that in an inner portion due to the temperature difference, resulting in generation of stress and generation of cracks. They have reached the present invention through their finding that forming a resistance heating element adjacent to an outermost circumference of the ceramic substrate can prevent such trouble.

That is, the present invention provides a ceramic heater comprising a ceramic substrate which is principally in a disc shape, and a resistance heating element formed on the surface thereof,
wherein the outermost circumference of a resistance heating element-formed area is located within 35 mm from the side face of the ceramic substrate.

In the present invention, a resistance heating element is formed on the surface of a ceramic substrate and therefore, it is easy to measure a resistance value thereof and it is possible to bring a cooling fluid directly into contact with the resistance heating element when cooling the resistance heating element, thereby to realize rapid temperature falling. Moreover, since a heating face is formed in the opposite face to a resistance heating element-formed face so that heat diffuses as the heat is transmitted from the resistance-formed face to the heating face. On the other hand, dissimilar to the case that a heating element exists inside thereof, since the side face of the heating element is not in contact with the ceramic substrate, the temperature of the periphery easily falls. In the present invention, the outermost circumference of a resistance heating element-formed area is located within 35 mm from the side face of the above-mentioned ceramic substrate, thus fall of the the temperature of the periphery thereof is prevented by adopting such a constitution. Moreover, since the temperature of the periphery of the ceramic substrate does not fall, the generation of cracks caused by rapid temperature rising and rapid temperature falling can be prevented.

Furthermore, since a resistance heating element is formed within 35 mm from the side face of the ceramic substrate, it is not necessary to form an insulating ring, purposely.

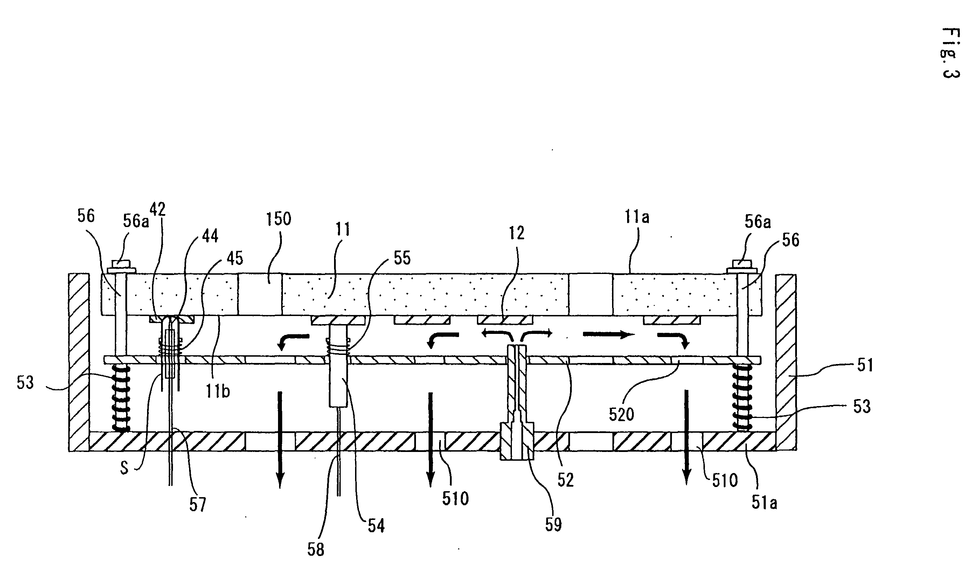

Due to this, the fall of the peripheral temperature of the ceramic substrate 11 can be prevented even if a ceramic substrate is fixed with a supporting case (a casing) 51 through a supporting pillar 56 in the manner that the ceramic substrate is held with being in non-contact with the supporting case 51 as shown in Fig.3, thus the structure thereof can be simplified.

The above-mentioned ceramic substrate is desirably in a disc shape. This is because such a disc shape is required to have temperature evenness in its heating face, and therefore, the constitution of the present invention can exhibit a great effect.

The above-mentioned ceramic substrate desirably is a carbide ceramic or a nitride ceramic. This is because these are excellent in thermal conductivity.

The above-mentioned ceramic substrate desirably has a thickness of 25 mm or less. This is because the heat of the resistance heating element is easily conducted to the heating face and, therefore, the temperature of the periphery does not fall easily.

The diameter of the above-mentioned ceramic substrate desirably exceeds 150 mm, and most desirably exceeds 210 mm. This is because the temperature in the periphery easily falls because the area of the heating face is large and, therefore, the present invention can particularly exhibit its effect.

### Brief Description of the Drawings

Fig. 1 is a figure showing a pattern of a resistance heating element of a ceramic heater of the present invention.
Fig. 2 is a sectional view of a ceramic heater of the present invention.
Fig. 3 is a sectional view that illustrates an assembled ceramic heater of the present invention.

**Explanation of Symbols**

| | |
|---|---|
| 10 | ceramic heater |
| 11 | ceramic substrate |
| 12 | resistance heating element |
| 13 | terminal pin |
| 14 | bottomed hole |
| 15 | through hole |

### Detailed Disclosure of the Invention

The present invention will be described below in accordance with embodiments thereof.

The present invention provides a ceramic heater comprising a ceramic substrate which is principally in a disc shape, and a resistance heating element formed on the surface thereof,
wherein the outermost circumference of a resistance heating element-formed area is located within 35 mm from the side face of the ceramic substrate.

In the ceramic heater according to this embodiment, a nitride ceramic or a carbide ceramic is used as the ceramic substrate and an oxide ceramic is used as an insulating layer on the surface of the ceramic substrate. Incidentally, the volume resistance value of a nitride ceramic easily drops at a high temperature by the formation of solid solution of oxygen and the like, and a carbide ceramic has conductivity unless it is particularly highly purified. Thus, by forming an oxide ceramic as an insulating layer, short circuit can be prevented even at a high temperature or even if the carbide ceramic contains impurities, so that the temperature controllability is secured.

The surface of the ceramic substrate preferably has a face roughness of 0.05 to 20 µm in the value of Ra and 0.5 to 200 µm in the value of Rmax.

Examples of the nitride ceramic constituting the above-mentioned ceramic substrate include metal nitride ceramics such as aluminum nitride, silicon nitride, boron nitride, titanium nitride and the like.

Examples of the above-mentioned carbide ceramic include metal carbide ceramics such as silicon carbide, zirconium carbide, titanium carbide, tantalum carbide, tungsten carbide and the like.

As the ceramic substrate, an oxide ceramic may be used. Thus, alumina, silica, cordierite, mullite, zirconia, beryllia and the like can be used.

In the present invention, it is desired that the ceramic substrate contains a sintering aid therein. Examples of the sintering aid that can be used for aluminum nitride include alkali metal oxides, alkali earth metal oxides or rare-earth oxides. Particularly, CaO, Y₂O₃, Na₂O, Li₂O or Rb₂O₃ are preferable among these sintering aids. Alumina can also be used. The content of these sintering aids is desirably from 0.1 to 20% by weight.

In the case of silicon carbide, the sintering aid is desirably B₄C, C or AlN.

In the present invention, the ceramic substrate desirably contains 5 to 5000 ppm of carbon therein.

This is because the incorporation of carbon can blacken the ceramic substrate and it permits radiation heat to be sufficiently utilized when the substrate is used as a heater.

The carbon may be either amorphous one or crystalline one. This is because the use of amorphous carbon can prevent a drop in a volume resistivity at a high temperature and the use of crystalline carbon can prevent a drop in heat conductivity at a high temperature. Accordingly, depending on the purpose of use, both crystalline carbon and amorphous carbon may be used together. The content of carbon is more preferably 50 to 2000 ppm.

The thickness of the ceramic substrate of the present invention is desirably 50 mm or less, and especially desirably 25 mm or less.

If the thickness of the ceramic substrate exceeds 25 mm, the heat capacity of the ceramic substrate becomes too large, so that particularly when temperature control means is set up to heat or cool the ceramic substrate, the temperature following character may become poor due to the large heat capacity.

Particularly, the most suitable thickness is 5 mm or more. The thickness desirably exceeds 1.5 mm.

The dispersion of the thickness of the ceramic substrate is desirably within ±3%. The dispersion of the thermal conductivity of the ceramic substrate is desirably within ±10%.

As the insulating layer used in the present invention, an oxide ceramic is desirable. Specifically, silica, alumina, mullite, cordierite, beryllia and so on can be used.

Such an insulating layer can be formed by spin-coating a sol solution, which is prepared by hydrolyzing and polymerizing an alkoxide, to the ceramic substrate, followed by drying and firing the resultant. It may also be formed by sputtering, CVD and the like. Moreover, an oxide layer may be formed by subjecting the surface of a ceramic substrate to oxidation.

In the case of the ceramic heater of the present invention, a semiconductor wafer may be put on the wafer-putting face of the ceramic substrate so as to come in contact therewith. In some cases, a semiconductor wafer is supported with a supporting pin or a supporting ball to be held apart from the ceramic substrate at a certain distance.

The distance thereof is desirably 5 to 5000 µm.

Regarding a semiconductor wafer, by moving the lifter pins up and down, it is possible to receive the semiconductor wafer from a carrier machine, put the semiconductor wafer on a ceramic substrate, or heat the semiconductor wafer in the state that the semiconductor wafer is supported.

The diameter of the ceramic substrate of the present invention is desirably 200 mm or more. It is the most desirable that the diameter is 12 inches (300 mm) or more. This is because semiconductor wafers having such a diameter become a main stream of the next-generation semiconductor wafers and also because the temperature of the periphery easily falls, therefore the constitution of the present invention is effective.

The outer shape of the above-mentioned ceramic substrate is desirably equal to or larger than a semiconductor wafer. Heating may be conducted while the ceramic substrate being kept in non-contact with a semiconductor wafer.

The above-mentioned ceramic substrate desirably has closed pores, and the leakage amount of helium is desirably 10⁻⁷ Pa·m³/sec or less. This is to prevent a coolant gas for forcible cooling from leaking.

Furthermore, in order to secure the insulation between resistance heating elements, it is desirable to adjust the volume resistance of the ceramic substrate or the volume resistivity of the insulating layer to 10⁵ Ω·cm or more at a temperature of 100°C or more.

It is advantageous that the flatness of the ceramic substrate is 50 µm or less.

The ceramic heater of the present invention is used for a device for producing or examining semiconductors. Examples of specific devices include an electrostatic chuck, a wafer prober, a susceptor and the like.

When the ceramic heater is used as an electrostatic chuck, an electrostatic electrode and an RF electrode are formed in addition to the resistance heating element and when it is used as a wafer prober, a chuck top conductor layer as a conductor is formed on its surface, and a guard electrode and a ground electrode are formed as conductors inside the ceramic heater.

The ceramic substrate for semiconductor devices of the present invention is desirably used at a temperature of 100 °C or more, and most desirably at a temperature of 200 °C or more.

If necessary, in the present invention, a thermocouple may be embedded in a bottomed hole in the ceramic substrate. This is because the thermocouple makes it possible to measure the temperature of the resistance heating element and, on the basis of the measured data, voltage or electric current is changed so that the temperature can be controlled.

The size of the connecting portions of metal wires of the thermocouples is the same as or more than the strand diameter of the respective metal wires, and is preferably 0.5 mm or less. Such a structure reduces the heat capacity of the connecting portion and causes a temperature to be correctly and rapidly converted to a current value. For this reason, the temperature controllability is improved so that the temperature distribution in the heating face of a semiconductor wafer is reduced.

Examples of the above-mentioned thermocouple include K, R, B, S, E, J and T type thermocouples as described in JIS-C-1602 (1980).

The temperature-measuring elements may be bonded to the bottom of the bottomed hole 14 using gold solder, silver solder and the like, or may be inserted into the bottomed hole and then is sealed with a heat resistant resin. The both approaches may be used together.

Examples of the above-mentioned heat resistant resin include thermosetting resins, in particular, epoxy resins, polyimide resins and bismaleimide-triazine resins. These resins may be used alone or in combination of two or more.

The above-mentioned gold solder is desirably at least one selected from an alloy of 37 to 80.5 % by weight of Au-63 to 19.5 % by weight of Cu and an alloy of 81.5 to 82.5 % by weight of Au-18.5 to 17.5 % by weight of Ni. This is because these have a melting temperature of 900 °C or more and are not easily melted even in a high temperature range.

As the silver solder, for example, an Ag-Cu type one can be used.

As shown in Fig. 1, the heating element 12 is desirably divided into at least two circuits, and more desirably divided into 2 to 10 circuits. By dividing a circuit, each electric power supplied to the respective circuits can be controlled to change the calorific value thereof so that the temperature of the wafer heating face 11a can be adjusted.

Examples of the pattern of the heating element 12 include spirals and eccentric circles as well as the pattern comprising a combination of concentric circles-like and a winding line as shown in Fig. 1.

In the present invention, an insulating layer is formed before the formation of the heating element. The insulating layer can be formed by the spin-coating of a sol solution, which is prepared by hydrolyzing and polymerizing an alkoxide, to the surface of a ceramic substrate, followed by the drying and firing of the resultant, or by sputtering, CVD and the like. Moreover, an oxide layer may be formed by the firing of the surface of a ceramic substrate in an oxidizing atmosphere.

In case that the heating element is formed on the surface of the ceramic substrate 11, a preferable method is one comprising steps of : applying a conductor containing paste containing metal particles to the surface of the ceramic substrate 11 to form a conductor containing paste layer with a predetermined pattern; and then firing the conductor containing paste layer to sinter the metal particles on the surface of the ceramic substrate 11. If the metal particles are fused and adhered to each other and the metal particles and the ceramic are fused and adhered to each other in the sintering of the metal, the sintering is sufficient.

In this embodiment, a pattern like that shown in Fig. 1 is adopted. In the ceramic substrate 11, there exist 12d as a resistance heating element-formed area 1, 12c as a resistance heating element-formed area 2, 12b as a resistance heating element-formed area 3 and 12a as a resistance heating element-formed area 4. Also, buffering areas of resistance heating element-formed areas are formed between the resistance heating element-formed area 1 and the resistance heating element-formed area 2, between the resistance heating element-formed area 2 and the resistance heating element-formed area 3, and between the resistance heating element-formed area 3 and the resistance heating element-formed area 4. Because of the existence of these buffering areas, the rise of the temperature caused by the application of large electric power to the resistance heating element-formed area 2 gives no influence to the resistance heating element-formed area 1 or the resistance heating element-formed area 3. Thus, there is no necessity of temperature control, such as causing the temperature of the resistance heating element-formed area 1 or the resistance heating element-formed area 3 to fall. Thus, the temperature difference in the heating face can be reduced by simple control.

The outermost circumference of the resistance heating element-formed areas must be located within 35 mm from the side face of the above-mentioned ceramic substrate, and the most desirably within 25 mm. This is because if within 25 mm, the warp amount can be extremely small.

Furthermore, it is desirable to set the distance between the outermost circumference of the resistance heating element-formed areas and the side face of the above-mentioned ceramic substrate to be 0.5 mm or more. This is because if the distance is less than 0.5 mm, electric short circuit will occur or the handling property will be deteriorated in case that a supporting case is made of metal.

In the ceramic heater according to this embodiment, the width of the resistance heating element-formed areas is adjusted to 5 to 30% of the diameter thereof.

In the ceramic substrate 11, a through hole 15 is formed and a lifter pin is inserted in it.

The face roughness of the through hole is desirably 0.05 to 200 µm in the value of Rmax and 0.005 to 20 µm in the value of Ra.

In a bottomed hole 14, a temperature-measuring device is formed. On the resistance heating element 12, a terminal portion 13 is formed thereon.

As the resistance heating element-formed areas, a concentric, spiral, or winding pattern is formed. It is desirable that one resistance heating element-formed area has one circuit. This is because a resistance heating element-formed area with one circuit is easier to be controlled.

When the heating element is formed on the surface of the ceramic substrate 11, the thickness of the heating element 12 is preferably 1 to 30 µm and more preferably 1 to 10 µm.

When the heating element is formed on the surface of the ceramic substrate 11, the width of the heating element is preferably 0.1 to 20 mm and more preferably 0.1 to 5 mm.

The resistance value of the heating element 12 can be changed depending on its width or thickness. The above-mentioned ranges are however most practical. The resistance value becomes larger as the heating element becomes thinner and narrower.

By setting the position where the heating element is formed in such a manner, the heat generated from the heating element is diffused throughout the ceramic substrate during the transmission of the heat, resulting in the evenness of the temperature distribution of the face where an object to be heated (a silicon wafer) will be heated. As a result, the temperature of every portion of the object to be heated will become even.

The heating element may have a rectangular section or an elliptical section. It desirably has a flat section. This is because: in case of the flat section, heat is more easily radiated toward the wafer heating face. Thus, a temperature distribution on the wafer heating face is not easily generated.

The aspect ratio (the width of the heating element/the thickness of the heating element) of the section is desirably 10 to 5000.

Adjustment thereof into this range makes it possible to increase the resistance value of the heating element 12 and secure the evenness of the temperature on the wafer heating face.

In case that the thickness of the heating element 12 is made constant: if the aspect ratio is smaller than the above-mentioned range, the amount of heat conduction toward the wafer heating face of the ceramic substrate 11 becomes small so that a thermal distribution similar to the pattern of the heating element is generated on the wafer heating face; on the other hand, if the aspect ratio is too large, the temperature of the portions just above the middle line of the heating element becomes high so that a thermal distribution similar to the pattern of the heating element is also generated on the wafer heating face. Accordingly, if temperature distribution is considered, the aspect ratio of the section is preferably 10 to 5000.

When the heating element is formed on the surface of the substrate 11, the aspect ratio is desirably 10 to 200. When the heating element is formed inside the substrate 11, the aspect ratio is desirably 200 to 5000.

The aspect ratio becomes larger in case that the heating element is formed inside the substrate 11. This is because if the heating element is formed inside, the distance between the wafer heating face and the heating element becomes short and, therefore, the temperature evenness of the surface is deteriorated, this resulting in the necessity of flattening the heating element itself.

The conductor containing paste is not particularly limited, and is preferably a paste comprising not only metal particles or a conductive ceramic for keeping electrical conductivity but also a resin, a solvent, a thickener and the like.

The above-mentioned metal particles are preferably of, for example, a noble metal (gold, silver, platinum and palladium) , lead, tungsten, molybdenum, nickel and the like. These may be used alone or in combination of two or more. This is because these metals are not relatively easily oxidized and have a sufficient resistance value to generate heat.

Examples of the above-mentioned conductive ceramic include carbides of tungsten, molybdenum and the like. These may be used alone or in combination of two or more.

The particle diameter of these metal particles or the conductive ceramic is preferably 0.1 to 100 µm. If the particle diameter is too fine, that is, less than 0.1 µm, they are easily oxidized. On the other hand, if the particle diameter exceeds 100 µm, they are not easily sintered so that the resistance value becomes large.

The shape of the above-mentioned metal particles may be spherical or scaly. When these metal particles are used, they may be a mixture of spherical particles and scaly particles.

In case that the above-mentioned metal particles are scaly or a mixture of spherical particles and scaly particles, metal oxides between the metal particles are easily retained and adhesion between the heating element and the nitride ceramic and the like is made sure. Moreover, the resistance value can be made large. Thus, these cases are profitable.

Examples of the resin used in the conductor containing paste include epoxy resins, phenol resins and the like . Examples of the solvent are isopropyl alcohol and the like. Examples of the thickener are cellulose and the like.

As for the conductor containing paste, it is desirable that metal oxide is added to metal particles so that the heating element is composed of a material prepared by sintering the metal particles and the metal oxide. By sintering the metal oxide together with the metal particles in this way, nitride ceramic or carbide ceramic, which is a ceramic substrate, can be firmly adhered to the metal particles.

The reason why the adhesion to the nitride ceramic or carbide ceramic is improved by mixing the metal oxide is unclear , but would be based on the following. The surface of the metal particles or the surface of the nitride ceramic or carbide ceramic is slightly oxidized so that oxidized films are formed thereon. The oxidized films are sintered to integrate through a metal oxide, and as a result, the metal particles are adhered firmly to the nitride ceramic or the carbide ceramic.

Preferred examples of the above-mentioned metal oxide include at least one selected from the group consisting of lead oxide, zinc oxide, silica, boron oxide (B₂O₃), alumina, yttria and titania.

These oxides make it possible to improve adhesion between the metal particles and the nitride ceramic or the carbide ceramic without increasing the resistance value of the heating element.

When the total amount of the metal oxides is set to 100 parts by weight, the weight ratios of the above-mentioned lead oxide, zinc oxide, silica, boron oxide (B₂O₃), alumina, yttria and titania are as follows: lead oxide: 1 to 10, silica: 1 to 30, boron oxide: 5 to 50, zinc oxide: 20 to 70, alumina: 1 to 10, yttria: 1 to 50 and titania: 1 to 50. The weight ratios are preferably adjusted within the range that the total thereof does not exceed 100 parts by weight.

By adjusting the amounts of these oxides within those ranges, the adhesion to the nitride ceramic can be particularly improved.

The addition amount of the above-mentioned metal oxides to the metal particles is preferably 0.1 % by weight or more and less than 10 % by weight. The area resistivity achieved when the conductor containing paste having such a composition is used to form the heating element is preferably from 1 to 45 mΩ/□.

This is because if the area resistivity exceeds 45 mΩ/□, the amount of heat generated to the applied voltage becomes too small so that, in the ceramic substrate 11 wherein a heating element is formed on its surface, the amount of the heat generated is not easily controlled. If the addition amount of the metal oxides is 10% by weight or more, the area resistivity exceeds 50 mΩ/□ so that the amount of the heat generated becomes too small. Thus, temperature control is not easily performed so that the evenness in temperature distribution is deteriorated.

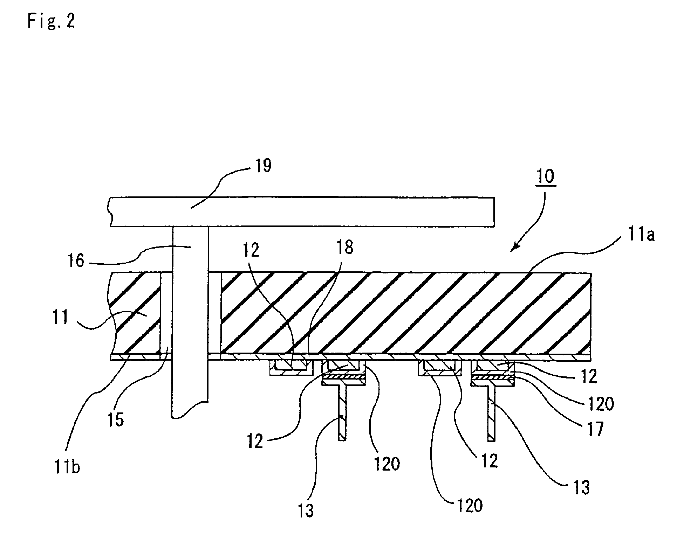

In case that the heating element is formed on the surface of the substrate 11, a metal covering layer (reference to Fig. 2) 120 is desirably formed on the surface portion of the heating element. This is because the metal covering layer prevents a change in the resistance value due to the oxidization of the internal metal sintered body. The thickness of the metal covering layer 120 to be formed is preferably from 0.1 to 10 µm.

The metal to be used for forming the metal covering layer 120 is not particularly limited if the metal is a metal which is hardly oxidized. Specific examples thereof include gold, silver, palladium, platinum, nickel and the like. These may be used alone or in combination of two or more. Among these metals, nickel is preferred.

In the heating element, a terminal for connecting it to a power source is necessary. This terminal is fixed to the heating element through a solder. Therein, Nickel prevents a solder from being thermally diffused. An example of the connecting terminal is a terminal pin 13 made of Koval.

In case that the connecting terminal is connected, an alloy such as silver-lead, lead-tin or bismuth-tin can be used as a solder. The thickness of the solder layer is desirably from 0.1 to 50 µm. This is because this range is a range sufficient for securing the connection by the solder.

Next, a description will be made to a manufacturing process of a ceramic heater of the present invention.

The following will describe a manufacturing process of a ceramic heater 10 wherein a heating element is formed inside a ceramic substrate (reference to Fig. 2).

### (1) Step of forming a ceramic heater

A slurry is prepared by blending powder made of the above-mentioned nitride ceramic or carbide ceramic with a sintering aid such as yttria, a binder and so on, based on the necessity. Thereafter, this slurry is made into a granular form by spray drying and the like. The granule is put into a mold and is pressed to form into a plate form and the like. Thus, a raw formed body (green) is prepared.

Next, a portion that will become a through hole 15 into which a supporting pin for supporting a silicon wafer is inserted; and a portion that will become a bottomed hole 14 in which a temperature measuring element such as a thermocouple is embedded: are formed in the raw formed body, if necessary.

Next, this raw formed body is heated and is fired for sintering. Thus, aplate-formed body made of ceramic is produced. Thereafter, the plate-formed body is made into a predetermined shape to produce a substrate 11. The raw formed body may have such a shape that it can be used as it is after firing. Heating and firing the raw formed body under pressure can produce a substrate 11 free from pores. It is sufficient that the heating and the firing are performed at the sintering temperature or more. The firing temperature is 1000 to 2500 °C for nitride ceramic or carbide ceramic. It is to be noted that the through hole, the bottomed hole and so on may be formed after the production of the sintered body.

### (2) Step of printing a conductor containing paste on a substrate

A conductor containing paste is generally a fluid comprising metal particles, a resin and a solvent and having a high viscosity. This conductor containing paste is printed, by screen printing and the like, in the portion where a heating element is to be arranged to form a conductor containing paste layer. Since it is necessary that the heating element makes the temperature of the whole of the substrate even, the conductor containing paste is desirably printed into a pattern comprising a combination of concentric circles-like and winding lines as shown in Fig. 1.

The conductor containing paste layer is desirably formed in the manner that a section of the heating element 12 after firing is rectangular and flat. The conductor containing paste layer must be formed so that the outermost circumference of the resistance heating element-formed area of the ceramic substrate to be obtained is located within 35 mm from the side face of the ceramic substrate.

### (3) Firing of a conductor containing paste

The conductor containing paste layer printed on the bottom face of the substrate is heated and is fired to remove the resin and the solvent, and the metal particles are sintered. Thus, the metal particles are baked onto the bottom face of the substrate 11 to form the heating element 12. The heating and firing temperature is preferably 500 to 1000 °C.

If the above-mentioned metal oxides are added to the conductor containing paste, the metal particles, the substrate and the metal oxides are sintered to integrate with each other. Thus, the adhesion between the heating element 12 and the substrate 11 is improved.

### (4) Step of forming a metal covering layer

A metal covering layer is desirably formed on the surface of the heating element 12. The metal covering layer can be formed by electroplating, electroless plating, sputtering and the like. From the viewpoint of mass-productivity, electroless plating is most suitable.

### (5) Attaching of terminals, etc.

A terminal (a terminal pin 13) for connecting to a power source is attached to an end of the pattern of the heating element 12 with a solder. A thermocouple is fixed to the bottomed hole 14 with a silver solder, a gold solder and the like. The bottomed hole 14 is sealed with a heat resistant resin such as a polyimide to finish the manufacture of the ceramic heater 10.

The ceramic heater of the present invention may be provided with an electrostatic electrode to be used as an electrostatic chuck, and also may be provided with a chuck top conductor layer to be used as a wafer prober.

An assembled structure of this ceramic heater is shown in Fig. 3.

In this ceramic heater 10, a resistance heating element 12 is formed on a ceramic substrate 11. The face opposing the face on which the resistance heating element is formed is a wafer heating face 11a. The ceramic heater 10 is fixed to a supporting case (a casing) 51 through a supporting pillar 56. Thus, there is no insulating ring. In the present invention, the falling of the temperature of the peripheral portion thereof can be inhibited without any insulating ring. The ceramic substrate 11 is in non-contact with the supporting case 51. A fixing metal member 56a is attached to the supporting pillar 56. Furthermore, a through hole 150 through which a lifter pin is inserted is formed in the ceramic substrate 11. A power-supplying terminal 54 is fixed to the resistance heating element through a spring 55. Furthermore, an intermediate bottom plate 52 and a bottom plate 51a are fixed to the supporting case 51. An opening 510 is formed on the bottom plate 51a. The intermediate bottom plate 52 is fixed in a space inside the supporting case 51 with a spring 53. The bottom plate 51a is provided with a cooling nozzle 59. Cooling is conducted by blowing the air and the like. Moreover, a thermocouple 44 for temperature controlling is pressed on the bottom plate 51a with a spring 45 through a heat transfering plate 42.

Best Mode for Carrying out the Invention (Example 1) Production of a ceramic heater made of SiC (reference to FIGS. 1, 2)
(1) A composition made of 100 parts by weight of SiC powder (average particle diameter: 0.3 µm), 4 parts by weight of a sintering aid, that is B₄C, 12 parts by weight of an acrylic binder and an alcohol was subjected to spray-drying to form granular powder.
(2) Next, this granular powder was put into a mold and was formed into a flat plate form to obtain a raw formed body (green) .
(3) The raw formed body subjected to the above-mentioned treatment was hot-pressed at 2100 °C and a pressure of 18 MPa to obtain a ceramic plate made of SiC having a thickness of 3 mm.
   Next, this plate-formed body was cut into a disc having a diameter of 210 mm and was ground into a mirror plane until its surface has an Ra value of 0.1 µm, thus to obtain a ceramic substrate 11.
   A film of SiO₂ having a thickness of 2 µm was formed on the surface of the ceramic substrate 11 made of SiC by applying a sol solution which is prepared by hydrolyzing and polymerizing a mixed solution composed of 25 parts by weight of tetraethyl silicate, 37.6 parts by weight of ethanol and 0.3 part by weight of hydrochloric acid for 24 hours under stirring, to the ceramic substrate 11 by spin-coating, followed by drying it at 80 °C for 5 hours, then followed by firing it at 1000 °C for 1 hour.
   The resulting formed body was subjected to drilling to form a portion that would become a through hole 15 into which a supporting pin for a silicon wafer is inserted and a portion (diameter: 1.1 mm, depth: 2 mm) that would become a bottomed hole 14 in which a thermocouple is embedded.
(4) A conductor containing paste was printed, by screen printing, on the ceramic substrate 11 obtained in the step (3). The pattern of the printing was a pattern of a combination of concentric circles-like and winding lines as shown in Fig. 1.
   Incidentally, the outermost circumference of the resistance heating element-formed area was located 30 mm apart from the side face of the above-mentioned ceramic substrate.
   The used conductor containing paste was Solvest PS603D made by Tokuriki Kagaku Kenkyusho Co., which is used to form plated through holes in printed circuit boards.
   This conductor containing paste was a silver paste and contained 7.5 parts by weight of metal oxides comprising lead oxide (5% by weight), zinc oxide (55% by weight), silica (10% by weight) , boron oxide (25% by weight) and alumina (5% by weight) per 100 parts by weight of silver. The silver particles had an average particle diameter of 4.5 µm and were scaly.
(5) Next, the ceramic substrate 11 on which the conductor containing paste was printed was heated and fired at 780 °C to sinter silver in the conductor containing paste and bake it onto the substrate 11. Thus, a heating element 12 was formed. The silver heating element 12 had a thickness of 5 µm, a width of 2.4 mm and an area resistivity of 7.7 mΩ/□.
(6) The substrate 11 prepared in the step (5) was immersed into an electroless nickel plating bath comprising an aqueous solution containing 80 g/L of nickel sulfate, 24 g/L of sodium hypophosphite, 12 g/L of sodium acetate, 8 g/L of boric acid, and 6 g/L of ammonium chloride to precipitate a metal covering layer (nickel layer) 120 having a thickness of 1 µm on the surface of the silver-lead heating elements 12.
(7) By screen printing, a silver-lead solder paste (made by Tanaka Kikinzoku Kogyo Co.) was printed on the portion to which a terminal for securing connection to a power source would be attached, to form a solder layer.
   Next, a terminal pin 13 made of Koval was mounted on the solder layer and was heated for reflowing at 420 °C. Thus, the terminal 13 was attached to the surface of the heating element 12.
(8) A thermocouple for controlling temperature was fitted into the bottomed hole 14 and a ceramic adhesive (ARON CERAMIC, made by TOAGOSEI Co., LTD.) was embedded thereinto. Thus, a ceramic heater 10 was obtained.

### (Example 2)

The operation was conducted according to Example 1, but the outermost circumference of the resistance heating element-formed area was located 20 mm apart from the side face of the above-mentioned ceramic substrate.

### (Example 3)

The operation was conducted according to Example 1, but the outermost circumference of the resistance heating element-formed area was located 10 mm apart from the side face of the above-mentioned ceramic substrate.

### (Example 4)

The operation was conducted according to Example 1, but the outermost circumference of the resistance heating element-formed area was located 1 mm apart from the side face of the above-mentioned ceramic substrate.

### (Comparative example 1)

The operation was conducted in the same manner as Example 1, but the outermost circumference of the resistance heating element-formed area was located 40 mm apart from the side face of the above-mentioned ceramic substrate.

### (Example 5) Production of a ceramic heater made of aluminum nitride (reference to FIGS. 1, 2)

(1) A composition made of 100 parts by weight of aluminum nitride powder (average particle diameter: 0.6 µm), 4 parts by weight of yttria (average particle diameter: 0.4 µm), 12 parts by weight of an acrylic binder and an alcohol was subjected to spray-drying to form granular powder.
(2) Next, this granular powder was put into a mold and was formed into a flat plate-form to obtain a raw formed body (green) .
(3) The raw formed body subjected to the above-mentioned treatment was hot-pressed at 1800 °C and a pressure of 20 MPa to obtain an aluminum nitride plate-formed body having a thickness of 3 mm.
   Next, this plate-formed body was cut into a disc having a diameter of 210 mm to form a ceramic substrate 11. To the surface of this substrate, the sol solution mentioned in Example 1 was applied and then was dried. The resultant was fired to form a SiO₂ film having a thickness of 2 µm.
   This formed body was subjected to drilling to form a portion which would become a through hole 15 into which a supporting pin for a silicon wafer is inserted and a portion (diameter: 1.1 mm, depth: 2 mm) which would become a bottomed hole 14 in which a thermocouple is embedded.
(4) A conductor containing paste was printed, by screen printing, on the substrate 11 obtained in the step (3). The pattern of the printing was a pattern of a combination of concentric circles-like and winding lines as shown in Fig. 1.
   Incidentally, the outermost circumference of the resistance heating element-formed area was located 30 mm apart from the side face of the above-mentioned ceramic substrate.
   The used conductor containing paste was Solvest PS603D made by Tokuriki Kagaku Kenkyusho Co., which is used to form plated through holes in printed circuit boards.
   This conductor containing paste was a silver-lead paste and contained 7.5 parts by weight of metal oxides comprising lead oxide (5% by weight) , zinc oxide (55% by weight) , silica (10% by weight), boron oxide (25% by weight) and alumina (5% by weight) per 100 parts by weight of silver. The silver particles had an average particle diameter of 4.5 µm and were scaly.
(5) Next, the substrate 11 on which the conductor containing paste was printed was heated and fired at 780 °C to sinter silver in the conductor containing paste and bake it onto the substrate 11. Thus, a heating element 12 was formed. The heating element 12 had a thickness of 5 µm, a width of 2.4 mm and an area resistivity of 7.7 mΩ/□.
(6) The substrate 11 prepared in the step (5) was immersed into an electroless nickel plating bath comprising an aqueous solution containing 80 g/L of nickel sulfate, 24 g/L of sodium hypophosphite, 12 g/L of sodium acetate, 8 g/L of boric acid, and 6 g/L of ammonium chloride to precipitate a metal covering layer (nickel layer) 120 having a thickness of 1 µm on the surface of the silver-lead heating elements 12.
(7) By screen printing, a silver-lead solder paste (made by Tanaka Kikinzoku Kogyo Co.) was printed on the portion to which a terminal for securing connection to a power source would be attached, to form a solder layer. Next, a terminal pin 13 made of Koval was mounted on the solder layer and was heated for reflowing at 420 °C. Thus, the terminal 13 was attached to the surface of the heating element 12.
(8) A thermocouple for controlling temperature was fitted into the bottomed hole 14 and a ceramic adhesive (ARON CERAMIC, made by TOAGOSEI Co., LTD.) was embedded thereinto. Thus, a ceramic heater 10 was obtained.

### (Example 6)

The operation was conducted according to Example 5, but the outermost circumference of the resistance heating element-formed area was located 20 mm apart from the side face of the above-mentioned ceramic substrate.

### (Example 7)

The operation was conducted according to Example 5, but the outermost circumference of the resistance heating element-formed area was located 10 mm apart from the side face of the above-mentioned ceramic substrate.

### (Example 8)

The operation was conducted according to Example 5, but the outermost circumference of the resistance heating element-formed area was located 1 mm apart from the side face of the above-mentioned ceramic substrate.

### (Comparative example 2)

The operation was conducted in the same manner as Example 8, but the outermost circumference of the resistance heating element-formed area was located 40 mm apart from the side face of the above-mentioned ceramic substrate.

This comparative example was conducted according to the manufacturing method of a ceramic heater disclosed in JP Kokai Hei 11-40330. In this heater, as shown in Fig. 1 of JP Kokai 2000-299281, an insulating ring is disposed in the peripheral portion, and therefore, there is no heating element in the peripheral portion.

### (Comparative example 3)

(1) A green sheet having a thickness of 0.47 µm was obtained through the formation by the doctor blade method using a paste obtained by mixing 100 parts by weight of aluminum nitride powder (made by Tokuyama Corp., average particle diameter: 1.1 µm), 4 parts by weight of yttria (average particle diameter: 0.4 µm), 11.5 parts by weight of an acrylic binder, 0.5 part by weight of a dispersant and 53 parts by weight of an alcohol comprising 1-butanol and ethanol.
(2) Next, this green sheet was dried at 80 °C for 5 hours, and was subjected to punching to form portions which would become through holes 15 having diameters of 1.8 mm, 3.0 mm and 5.0 mm, respectively, into which semiconductor wafer supporting pins are inserted and portions which would become conductor-filled through holes for connection to external terminals.
(3) A conductor containing paste A was prepared by mixing 100 parts by weight of tungsten carbide particles having an average particle diameter of 1 µm, 3.0 parts by weight of an acrylic binder, 3.5 parts by weight of α-terpineol solvent and 0.3 part by weight of a dispersant.
   A conductor containing paste B was prepared by mixing 100 parts by weight of tungsten particles having an average particle diameter of 3 µm, 1.9 parts by weight of an acrylic binder, 3.7 parts by weight of α-terpineol solvent and 0.2 part by weight of a dispersant.
   This conductor containing paste A was printed on the green sheet by screen printing to form a conductor containing paste layer for a resistance heating element. The pattern of the printing was a concentric pattern.
   Furthermore, the conductor containing paste B was filled into the through holes for the formation of conductor-filled through holes for connecting external terminals.
   On the green sheet that had been subjected to the above-mentioned processing, thirty four green sheets having no tungsten paste printed were stacked on (on the heating face of) the green sheet 50, and thirteen sheets of the same green sheets having no tungsten paste printed were stacked under the green sheet 50. Furthermore, a green sheet 50 having a printed conductor containing paste layer having an electrostatic electrode pattern was stacked thereon. Furthermore, two green sheets 50' having no tungsten paste printed were stacked thereon. The resultant was pressed at 130 °C and a pressure of 8 MPa to form a lamination.
(4) Next, the resultant lamination was degreased at 600 °C in the atmosphere of nitrogen gas for 5 hours and hot-pressed at 1890 °C and a pressure of 15 MPa for 3 hours to obtain an aluminum nitride plate-formed body of 3 mm in thickness. This was cut into a disc having 230 mm in diameter to form a ceramic substrate made of aluminum nitride that had a resistance heating element having a thickness of 6 µm and a width of 10 mm inside. The resistance heating element inside the ceramic substrate was disposed in a manner that the outermost circumference of the resistance heating element-formed area was located 30 mm apart from the side face of the above-mentioned ceramic substrate.
(5) Next, the plate-formed body obtained in the step of (4) was ground with a diamond grindstone. Subsequently, a mask was mounted thereon, and bottomed holes (diameter: 1.2 mm, depth: 2.0 mm) for fitting thermocouples were formed in the surface by blast treatment with SiC and the like.
(6) Furthermore, portions where the conductor-filled through holes were formed were hollowed out to form blind holes. To the blind holes, external terminals made of Koval were connected by heating and reflowing at 700 °C using brazing gold comprising Ni-Au.
   As for the connection of the external terminals, a structure wherein a support of tungsten supports at three points is desirable. This is because the reliability of the connection can be secured.
(7) Next, thermocouples for controlling temperature were embedded in the bottomed holes.

### (Example 9) Production of a ceramic heater made of SiC

(1) A composition made of 100 parts by weight of SiC powder (average particle diameter: 0.3 µm), 4 parts by weight of a sintering aid, that is B₄C, 12 parts by weight of an acrylic binder and an alcohol was subjected to spray-drying to form granular powder.
(2) Next, this granular powder was put into a mold and was formed into a flat plate form to obtain a raw formed body (green) .
(3) The raw formed body subjected to the above-mentioned treatment was hot-pressed at 2100 °C and a pressure of 18 MPa to obtain an SiC ceramic plate having a thickness of 3 mm.
   Next, this plate-formed body was cut into a disc having a diameter of 310 mm and was mirror-ground until its surface has an Ra value of 0.1 µm, thus to obtain a ceramic substrate 11.
   A film of SiO₂ having a thickness of 2 µm was formed on the surface of the ceramic substrate 11 made of SiC by applying a sol solution prepared by hydrolyzing and polymerizing a mixed solution composed of 25 parts by weight of tetraethyl silicate, 37.6 parts by weight of ethanol and 0.3 part by weight of hydrochloric acid for 24 hours under stirring, to the ceramic substrate 11 by spin-coating, followed by drying it at 80 °C for 5 hours, then followed by firing it at 1000 °C for 1 hour.
   The resulting formed body was subjected to drilling to form a portion that would become a through hole 15 into which a supporting pin for a silicon wafer is inserted and a portion (diameter: 1.1 mm, depth: 2 mm) that would become a bottomed hole 14 in which a thermocouple is embedded.
(4) A conductor containing paste was printed, by screen printing, on the ceramic substrate 11 obtained in the step (3). The pattern of the printing was a pattern of a combination of concentric circles-like and winding lines as shown in Fig. 1.
   Incidentally, the outermost circumference of the resistance heating element-formed area was located 0.5 mm apart from the side face of the above-mentioned ceramic substrate.
   The used conductor containing paste was Solvest PS603D made by Tokuriki Kagaku Kenkyusho Co., which is used to form plated through holes in printed circuit boards.
   This conductor containing paste was a silver paste and contained 7.5 parts by weight of metal oxides comprising lead oxide (5% by weight) , zinc oxide (55% by weight), silica (10% by weight) , boron oxide (25% by weight) and alumina (5% by weight) per 100 parts by weight of silver. The silver particles had an average particle diameter of 4.5 µm and were scaly.
(5) Next, the ceramic substrate 11 on which the conductor containing paste was printed was heated and fired at 780 °C to sinter silver in the conductor containing paste and bake it onto the substrate 11. Thus, a heating element 12 was formed. The silver heating element 12 had a thickness of 5 µm, a width of 2.4 mm and an area resistivity of 7.7 mΩ/□.
(6) The substrate 11 prepared in the step (5) was immersed into an electroless nickel plating bath comprising an aqueous solution containing 80 g/L of nickel sulfate, 24 g/L of sodium hypophosphite, 12 g/L of sodium acetate, 8 g/L of boric acid, and 6 g/L of ammonium chloride to precipitate a metal covering layer (nickel layer) having a thickness of 1 µm on the surface of the silver-lead heating elements 12.
(7) By screen printing, a silver-lead solder paste (made by Tanaka Kikinzoku Kogyo Co.) was printed on the portion to which a terminal for securing connection to a power source would be attached, to form a solder layer.
   Next, a terminal pin 13 made of Koval was mounted on the solder layer and was heated for reflowing at 420 °C. Thus, the terminal 13 was attached to the surface of the heating element 12.
(8) Athermocouple for controlling temperature was fitted into the bottomed hole 14 and a ceramic adhesive (ARON CERAMIC, made by TOAGOSEI Co., LTD.) was embedded thereinto. Thus, a ceramic heater was obtained.

### (Example 10)

The operation was conducted in the same manner as Example 9, but the outermost circumference of the resistance heating element-formed area was located 35 mm apart from the side face of the above-mentioned ceramic substrate.

### (Comparative example 4)

The operation was conducted in the same manner as Comparative example 3, but the distance from the outermost circumference of the resistance heating element-formed area to the side face of the ceramic substrate was set to 40 mm.

### (Comparative example 5)

The operation was conducted in the same manner as Example 9, but the outermost circumference of the resistance heating element-formed area was located 40 mm apart from the side face of the above-mentioned ceramic substrate. This comparative example is according to JP Kokai Hei 11-40330. In this heater, as shown in Fig. 1 of JP Kokai 2000-299281, an insulating ring is disposed in the peripheral portion, and therefore, there is no heating element in the peripheral portion.

### (Comparative example 6)

The operation was conducted in the same manner as Example 1, but the diameter of the ceramic substrate was set to 150 mm and the outermost circumference of the resistance heating element-formed area was located 40 mm apart from the side face of the above-mentioned ceramic substrate.

### (Comparative example 7)

The operation was conducted in the same manner as Example 9, but the outermost circumference of the resistance heating element-formed area was located 0.2 mm apart from the side face of the above-mentioned ceramic substrate. When an electric current was passed in the heating element, the discharge from the heating element to the supporting case occurred.

Furthermore, each of the heaters of the Examples and the Comparative examples was assembled into a supporting case as shown in Fig. 3 to form a unit and was heated to 400 °C. The temperature difference between the periphery and the inner portion was measured using a thermoviewer (IR-16-2012-0012, manufactured by Japan Datum Co., Ltd.) Moreover, the temperature was raised to 400 °C over 45 seconds and the incidence of cracks was examined. Furthermore, the temperature-falling time was measured by performing forcible cooling from 200 °C to 150 °C by blowing the air.

The results are shown in Table 1.

**Table 1**

| | Distance between the outer circumference of a resistance heating element and the outer circumference of a ceramic substrate (mm) | Temperature difference (°C) | Cracks (%) | Temperature-falling time (min.) |
|---|---|---|---|---|
| Example 1 | 30 | 4 | 0 | 2 |
| Example 2 | 20 | 4 | 0 | 2 |
| Example 3 | 10 | 3 | 0 | 2 |
| Example 4 | 1 | 3 | 0 | 2 |
| Example 5 | 30 | 4 | 0 | 2 |
| Example 6 | 20 | 4 | 0 | 2 |
| Example 7 | 10 | 4 | 0 | 2 |
| Example 8 | 1 | 3 | 0 | 2 |
| Example 9 | 0.5 | 2 | 0 | 2 |
| Example 10 | 35 | 4 | 0 | 2 |
| Comparative example 1 | 40 | 8 | 4 | 2 |
| Comparative example 2 | 40 | 8 | 4 | 2 |
| Comparative example 3 | 30 | 4 | 0 | 10 |
| Comparative example 4 | 40 | 4 | 4 | 10 |
| Comparative example 5 | 40 | 12 | 7 | 2 |
| Comparative example 6 | 40 | 5 | 2 | 2 |
| Comparative example 7 | 0.2 | - | - | - |

As is clear from the results shown in Table 1, a cooling time can be shortened by forming a resistance heating element on a surface. Moreover, the formation of a resistance heating element on a surface makes the temperature difference in a heating surface large (from a comparison of Comparative examples 2 and 4). The forming of a resistance heating element within 35 mm from the side face of a ceramic substrate makes the temperature difference in a heating face small. In addition, no crack is formed even by rapid temperature rising (from a comparison between Examples 1 to 10 and Comparative examples).

Moreover, a comparison of Comparative example 1 and Comparative example 5 shows that a ceramic substrate with a larger diameter gives a larger temperature difference.

Furthermore, a comparison of Comparative Example 1 and Comparative example 6 shows that a ceramic substrate with a smaller diameter gives a smaller temperature difference.

The present invention has solved the problem of falling of peripheral temperature observed in large ceramic heaters having diameters exceeding 150 mm. The effect of the present invention is remarkable when a ceramic heater has a diameter exceeding 210 mm.

### Industrial Applicability

As described above, according to the present invention, a heater can be realized, in which: it is easy to forcibly cool remaining heat in a heating element; it is easy to control the resistance value of the heating element; the temperature of the periphery of the heater does not become lower than a set value; and no cracks are generated by rapid temperature rising or rapid temperature falling.

## Claims

1. A ceramic heater comprising a ceramic substrate and a resistance heating element formed on the surface thereof,
wherein the outermost circumference of a resistance heating element-formed area is located within 35 mm from the side face of said ceramic substrate.

2. The ceramic heater according to claim 1,
wherein said ceramic substrate is in a disc shape.

3. The ceramic heater according to claim 1 or 2,
wherein said ceramic substrate is a carbide ceramic or a nitride ceramic.

4. The ceramic heater according to claim 1 or 2,
wherein the thickness of said ceramic substrate is 25 mm or less.

5. The ceramic substrate according to claim 1 or 2,
wherein the diameter of said ceramic substrate exceeds 150 mm.
